# EUROPÄISCHE PATENTSCHRIFT

(11) **EP 2 148 441 B1**
(45) Veröffentlichungstag und Bekanntmachung des Hinweises auf die Patenterteilung: **26.10.2011**
(21) Anmeldenummer: 09005608.6
(22) Anmeldetag: 22.04.2009
(51) Int. Cl.: H03K 17/22

(54) **Verfahren und Vorrichtung zum selbsttätigen Initialisieren eines integrierten Schaltkreises, selbsttätig initialisierbarer integrierter Schaltkreis und elektrisches Gerät mit einem solchen Schaltkreis**
Method and device for self-actuated initialising of an integrated circuit, self-actuated initialising of an integrated circuit and electrical device with such an integrated circuit
Procédé et dispositif d'initialisation automatique d'un circuit intégré, circuit intégré pouvant être initialisé de manière automatique et appareil électrique doté d'un tel circuit

(30) Priorität: 26.07.2008 DE 102008034926
(43) Veröffentlichungstag der Anmeldung: 27.01.2010
(73) Patentinhaber: Thales Defence Deutschland GmbH, 75175 Pforzheim (DE)
(72) Erfinder: Lüdecke, Rainer, 75217 Birkenfeld (DE)
(74) Vertreter: Wörz, Volker Alfred

(56) Entgegenhaltungen:
- EP-A- 1 233 328
- JP-A- 57 048 830
- US-A1- 2006 044 028
- US-B1- 6 492 848
- US-B1- 6 683 481

## Beschreibung

Die vorliegende Erfindung betrifft eine Vorrichtung und ein Verfahren zum selbsttätigen Initialisieren eines elektrischen integrierten Schaltkreises mittels eines Einschalt-Rücksetz-Signals nachdem eine Betriebsspannung an den Schaltkreis angelegt ist. Die Erfindung betrifft außerdem einen elektrischen integrierten Schaltkreis mit Mitteln zum Anlegen einer Betriebsspannung. Schließlich betrifft die Erfindung ein elektrisches Gerät umfassend einen elektrischen integrierten Schaltkreis und eine Vorrichtung zum selbsttätigen Initialisieren eines elektrischen integrierten Schaltkreises mittels eines Einschalt-Rücksetz-Signals nachdem eine Betriebsspannung an den Schaltkreis angelegt ist.

Aus dem Patent US 6,683,481 B1 ist ein Reset-Generator bekannt, der eine Hysterese aufweist, sodass er in Schaltungen einsetzbar ist, deren Versorgungsspannung Störungen aufweist.

Die Offenlegungsschrift US 2006/0044028 A1 zeigt einen Reset-Generator, der unabhängig von einer Flanke einer Versorgungsspannung ist.

Aus dem Stand der Technik ist es bekannt, integrierte Schaltkreise nach dem Einschalten, das heißt nach dem Anlegen einer Betriebsspannung, gezielt zu initialisieren, das heißt in einen definierten Anfangszustand zu überführen. Dies ist deshalb erforderlich, da integrierte Schaltkreise sowohl kombinatorische Funktionen (sog. logische Gatter)als auch Speicherelemente wie zum Beispiel Flip-Flops oder RAM-Zellen (RAM = Random Access Memory) umfassen. Diese können sich aus Gründen der gegenseitigen Beeinflussung und der physikalisch bedingten leicht unterschiedlichen Beaufschlagung mit Strom während des Einschaltzeitpunkts unvorhersehbar verhalten und somit auch nach dem Einschalten ebenfalls unvorhersehbare Zustände annehmen. Damit befindet sich der gesamte Schaltkreis in einem undefinierten Zustand und arbeitet fehlerhaft oder gar nicht.

Auch ein weiterer Effekt trägt zu diesem undefinierten Ausgangszustand des Schaltkreises bei. Die Speicherzellen im Schaltkreis behalten nach dem Ausschalten für einige Zeit ihre Ladung und verbleiben zumindest vorübergehend in ihrem letzten Zustand (Restladung).

Es soll darauf hingewiesen werden, dass sich der Begriff "Rücksetzen" im Zusammenhang mit der vorliegenden Erfindung auf das (Zurück-) Setzen des gesamten Schaltkreises in einen Initialzustand bezieht, unabhängig von dem hierfür erforderlichen logischen Zustand der internen Elemente des Schaltkreises. Diese können im zurückgesetzten Zustand je nach Funktion die logische Lage "0" oder "1" annehmen. Im Allgemeinen hat sich in Fachkreisen für das Einschalt-Rücksetz-Signal die englische Bezeichnung "Power-On-Reset" oder kurz POR etabliert. Diese Bezeichnung wird nachfolgend verwendet.

Der POR wird im Stand der Technik üblicherweise extern, das heißt außerhalb des integrierten Schaltkreises erzeugt und von extern an einen Eingang des Schaltkreises angelegt. Die externe Erzeugung eines PORs kann entweder manuell (z.B. mittels einer Reset-Taste) oder aber mittels einer externen Vorrichtung automatisch erfolgen.

Um eine automatische Initialisierung des Schaltkreises unmittelbar nach dem Anlegen der Betriebsspannung auslösen zu können, muss zunächst die Aktivierung der Betriebsspannung detektiert und dieses Ereignis als POR für eine ausreichend lange Zeitspanne an die zu initialisierenden Speicherelemente des Schaltkreises angelegt werden. Das heißt, dass der POR mit dem Einschalten des Schaltkreises aktiv und dann verzögert wieder inaktiv werden muss. Diese Verzögerungszeit ist technologisch abhängig von der Zeit, die die Speicherzellen nach Erreichen des operativen Zustands für ihre Initialisierung benötigen.

Herkömmliche Methoden zur automatischen Generierung eines POR sehen beispielsweise eine externe Vorrichtung mit einer Kondensator-Widerstands-Kombination vor, die verzögert mit der Betriebsspannung den POR erzeugt und diesen dann an einen Eingang des Schaltkreises anlegt. Der POR wird dann ausgewertet und zum Initialisieren des Schaltkreises genutzt. Außerdem gibt es eine ganze Reihe von kommerziellen externen Komponenten, die speziell und nur für diesen Zweck entwickelt wurden und separat auf der gleichen Platine wie der Schaltkreis aufgelötet für einen geordneten Einschaltvorgang sämtlicher dort befindlicher Bauteile sorgen. All diese bekannten Vorrichtungen und Verfahren haben gemeinsam, dass sie externe, von dem Schaltkreis separate Bauelemente sind oder benötigen.

Diese externen Komponenten verursachen Kosten (Herstellung der Bauteile, Testen der Bauteile, zusätzlicher Platzbedarf auf der Platine etc.) und stellen potentielle Fehlerquellen dar (mangelnde Zuverlässigkeit, Qualität etc.). Darüber hinaus kann der Einsatz externer Komponenten in sicherheitsrelevanten Anwendungen potenziellen Angreifern ermöglichen, durch Manipulation der externen Komponente, einen POR zu unterbinden. Aus diesen Gründen kann es nicht nur vorteilhaft, sondern sogar notwendig sein, die Erzeugung des POR in den integrierten Schaltkreis hinein zu verlagern. Es gilt also, in dem Schaltkreis intern eine Vorrichtung zum Rücksetzen des Schaltkreises zu implementieren, die nach dem Anlegen der Betriebsspannung einmalig ein Ereignis erzeugt, das dann die Initialisierung auslöst.

Soll sich der integrierte Schaltkreis den POR intern selbst erzeugen, ergibt sich das Problem, dass sich der Schaltkreis den Vollzug der Initialisierung in einem seiner Speicherelemente merken muss. Dieses befindet sich jedoch logischerweise, wie die restlichen Elemente im Schaltkreis auch, selbst in einem undefinierten Zustand. Das Speicherelement könnte also zufällig in dem Zustand "Initialisierung vollzogen" starten; die Initialisierung würde unterbunden werden, da scheinbar schon erfolgt. Somit sind die internen Speicherelemente zur Detektierung des Einschaltvorgangs und der Erzeugung der Verzögerungszeit, beispielsweise durch Implementierung eines digitalen Zählers, nicht nutzbar.

Denkbar wäre jedoch eine Nutzung der vorhandenen kombinatorischen Logik, z.B. eine Reihe von hinter einander geschalteten logischen Gattern, die durch die Addition ihrer inhärenten Verzögerungszeiten eine an das vorderste Gatter angelegte logische "1" (die Betriebsspannung) als hinreichend verzögerten POR an die Speicherelemente durchreichen könnte. Dies ist jedoch aus den nachfolgenden Gründen in der Praxis nicht realisierbar. Wegen der mittlerweile sehr hohen Komplexität integrierter Schaltkreise, werden für ihren Entwurf computerbasierte Werkzeuge eingesetzt. Diese führen üblicherweise in der Endphase einen oder mehrere Optimierungsdurchläufe aus, in deren Verlauf die Logik der zu implementierenden Funktionen hinsichtlich Komplexität und Zeitverhalten optimiert wird. Eine von einem Entwickler (durch Hintereinander-Schalten mehrerer logischer Gatter) absichtlich aufgeprägte interne Verzögerungszeit zur Erzeugung eines POR würde als unnötig interpretiert und von dem Entwurfswerkzeug verworfen werden. Manche dieser Werkzeuge lassen sich zwar durch spezielle Eingriffe daran hindern, diese in diesem speziellen Fall gewünschte Verzögerung anzutasten, dies wird aber von Werkzeug zu Werkzeug unterschiedlich und mit unterschiedlichen Auswirkungen gehandhabt und ist somit umständlich und fehleranfällig und kein in der Praxis allgemein, also unabhängig von dem verwendeten Werkzeug, gangbarer Weg.

Ausgehend von dem beschriebenen Stand der Technik liegt der vorliegenden Erfindung deshalb die Aufgabe zugrunde, eine Vorrichtung zum Initialisieren eines elektrischen integrierten Schaltkreises mittels eines POR dahingehend auszugestalten und weiterzubilden, dass die Vorrichtung in den Schaltkreis integriert werden kann, ohne einem der obigen Werkzeuge die Möglichkeit eines Eingriffs zu bieten, und diese Vorrichtung allgemein gültig ist, unabhängig von dem verwendetem Werkzeug und der eingesetzten Technologie.

Diese Aufgabe wird durch eine Vorrichtung gemäß Anspruch 1 und ein entsprechendes Verfahren gelöst. Die Vorrichtung ist integraler Bestandteil des zu initialisierenden Schaltkreises und zusammen mit dem Schaltkreis in Form eines programmierbaren logischen Bausteins ausgebildet. Mittel zum Detektieren des angelegten Betriebsspannungssignals, Mittel zum Verzögern des Spannungssignals und Mittel zum Anlegen des verzögerten Spannungssignals an den Schaltkreis als Einschalt-Rücksetz-Signal (POR) sind durch Konfiguration des programmierbaren logischen Bausteins realisiert.

Der Lösungsansatz geht dabei von der Tatsache aus, dass keines der bekannten computerbasierten Entwurfswerkzeuge einen Schaltkreiseingang eines programmierbaren logischen Bausteins oder eine auf den Eingang folgende funktionale Logik wegoptimieren kann. Es kommt noch hinzu, dass in vielen Typen logischer Bausteine für deren Eingänge implementierbare bzw. konfigurierbare Ziehelemente (bspw. in Form von Widerständen) zur Versorgungsspannung oder zur Masse zur Verfügung stehen. Und drittens kann von dem Umstand Gebrauch gemacht werden, dass Eingänge zur Anpassung von externen Signallaufzeiten vom Benutzer oftmals mit einer zusätzlichen internen Verzögerung durch Programmierung oder Konfiguration versehen werden können.

Somit kann das Detektieren des Einschaltvorgangs über einen solchen mit einem internen Ziehelement versehenen Schaltkreiseingang ohne schaltkreisexterne Beschaltung erfolgen. Bezüglich der Erzeugung der notwendigen Verzögerung wird zum einen erwähnt, dass der Eingang die vom Ziehelement verursachte Information erst im operativen Zustand weitergeben kann, und zum anderen, dass auch der Eingang, wie jedes andere Element des Schaltkreises auch, eine inhärente physikalisch bedingte verzögernde Eigenschaft aufweist. Doch diese wird sich je nach eingesetzter Technologie nur in wenigen Fällen als ausreichend erweisen. Eine zusätzliche Verzögerung kann jedoch mit folgenden Maßnahmen bzw. deren Kombinationen erreicht werden:
- Mittels einer dem Bausteineingang aufgeprägten, programmierbaren bzw. konfigurierbaren zusätzlichen Verzögerung und/oder
- mittels einer dem Eingang nachgeschalteten Logik, beispielsweise eines oder mehrerer Inverter oder logischer Gatter, deren zusätzlicher funktionaler Eingang bzw. zusätzliche Eingänge zur Unterbindung von Optimierungsvorgängen durch das verwendete Entwicklungswerkzeug ebenfalls jeweils an einen Schaltkreiseingang des Bausteins führen muss bzw. müssen.

Unter Umständen kann schon die alleinige Nachschaltung von Logik für die für einen POR notwendige Verzögerung ausreichend sein. In diesem Fall kann auf eine dem Schaltkreiseingang aufgeprägte programmierbare Verzögerung verzichtet werden.

Ein weiterer Vorteil der Erfindung ist darin zu sehen, dass bei sicherheitsrelevanten Anwendungen einem potentiellen Angreifer die Möglichkeit genommen wird, eine (Zwangs-) Initialisierung unmittelbar nach dem Anlegen der Betriebsspannung zu unterbinden. Der Schaltkreis würde zwar, wie oben ausgeführt, undefiniert starten oder gar nicht arbeiten, jedoch wäre es dem Angreifer eventuell möglich, aufgrund der physikalisch bedingten Tatsache, dass die Speicherelemente im Schaltkreis nach dem Ausschalten für eine gewisse Zeit ihre Ladung und somit ihren letzten Zustand und den damit verbundenen Informationsgehalt beibehalten, den Speicherinhalt vor dem letzten Ausschalten durch geeignete Methoden festzustellen. Dazu muss dem potentiellen Angreifer jedoch sowohl der Mechanismus als auch die Lage der Eingänge (Pins) am Logikbaustein bekannt sein, so dass er während und nach dem Einschaltvorgang die Funktion des bzw. der Ziehelemente unterbinden kann. Über solche Kenntnisse verfügt ein potentieller Angreifer in aller Regel jedoch nicht.

Selbst wenn dem hypothetischen Angreifer die Existenz, die Funktion und die Lage eines Eingangs zur Generierung des POR bekannt wäre, kann dem Angreifer durch die Wahl eines geeigneten Gehäuses für den Schaltkreis der Zugang zu diesem Eingang bei auf der Platine montiertem Schaltkreis verwehrt werden. Beispielsweise sind bei einem BGA-Gehäuse (Ball Grid Array) die Anschlüsse als kleine Lotperlen (Balls) gitterförmig an der Unterseite des Gehäuses angeordnet und im auf der Leiterplatte aufgelöteten Zustand nicht mehr erreichbar. Da der sensitive Eingang in keiner Weise von außen beschaltet ist, ist er auch mit keiner Leiterbahn verbunden und somit elektrisch nicht beeinflussbar.

Grundsätzlich kann die Erfindung in jeder Art von integrierten digitalen Schaltkreisen oder integrierten Schaltkreisen mit digitalen Anteilen realisiert werden. Jedoch seien hier die programmierbaren logischen Schaltkreise oder PLDs (Programmable Logic Devices) besonders genannt, da bei Ihnen der Entwickler nur auf den Vorrat der vom jeweiligen Hersteller bereitgestellten Ressourcen zurück greifen kann und diese seinen Wünschen entsprechend konfiguriert. Die aktuell wichtigsten Mitglieder der PLDs sind u.a. die FPGAs (Field Programmable Gate Arrays) und die CPLDs (Complex Programmable Logic Devices). Die CPLDs bieten nach heutigem Stand zwar nicht alle die für die obige beschriebene Methode zur Erzeugung eines internen POR notwendigen Ressourcen, also programmierbare Ziehelemente mit nachgeschalteter Logik und, bei noch unzureichender Verzögerung, eventuell eine zusätzliche programmierbare Verzögerung des Eingangs. In allen zur Zeit verfügbaren FPGAs neuerer Bauart stehen diese Ressourcen jedoch zur Verfügung. Als eines von vielen möglichen Ausführungsbeispielen sei eine Realisierung der Erfindung in einem FPGA der Firma Actel, Mountain View, CA 94043, USA, aus der Familie "ProAsic3E" erwähnt, einer auf der Flash-Technologie basierenden FPGA-Familie.

Der Kern'der vorliegenden Erfindung ist darin zu sehen, dass die Vorrichtung zum Initialisieren des elektrischen integrierten Schaltkreises integraler Bestandteil des Schaltkreises ist. Die Funktionalität der selbständigen internen Initialisierung gilt generell für einen integrierten Schaltkreis und ist unabhängig von seiner Aufgabe, der Baugruppe und des elektrischen Geräts, in der er diese Funktionalität erfüllt. Die interne Erzeugung des POR kann für beliebige Anwendungen eingesetzt werden. Sie ist für sicherheitsrelevante Anwendungen (z.B. in Geräten für kryptographische Anwendungen in der Kommunikationstechnik) wie auch für nicht sicherheitsrelevante Anwendungen (z.B. in Kraftfahrzeug-Steuergeräten, Kommunikationsendgeräten) von großem Vorteil.

Ein weiterer Aspekt der vorliegenden Erfindung ist darin zu sehen, dass die Vorrichtung besonders einfach, robust und kostengünstig ausgebildet ist, indem einfach das an dem Schaltkreis anliegende Betriebsspannungssignal detektiert, verzögert und das verzögerte Spannungssignal als POR an die restlichen Schaltkreiselemente angelegt wird. Die Verzögerung des angelegten Spannungssignals ist deshalb erforderlich, damit zunächst sämtliche Teile des Schaltkreises mit der Betriebsspannung versorgt werden (Erreichen eines operativen Zustands), bevor der POR angelegt und der integrierte Schaltkreis initialisiert wird. Im Anschluss an das Initialisieren des integrierten Schaltkreises steht dieser dann in einem definierten Anfangszustand für die weitere Verarbeitung zur Verfügung. Der integrierte Schaltkreis initialisiert sich also selbst.

Weitere Merkmale, Ausgestaltungen und Vorteile der vorliegenden Erfindung werden nachfolgend unter Bezugnahme auf die Figuren näher beschrieben. Es zeigen:
- Figur 1: ein erfindungsgemäßes elektrisches Gerät gemäß einer bevorzugten Ausführungsform;
- Figur 2: eine erfindungsgemäße Vorrichtung zur Initialisierung eines integrierten Schaltkreises gemäß einer ersten bevorzugten Ausführungsform;
- Figur 3: eine erfindungsgemäße Vorrichtung zur Initialisierung eines integrierten Schaltkreises gemäß einer zweiten bevorzugten Ausführungsform;
- Figur 4: eine erfindungsgemäße Vorrichtung zur Initialisierung eines integrierten Schaltkreises gemäß einer dritten bevorzugten Ausführungsform;
- Figur 5: die Verläufe ausgewählter Signale der erfindungsgemäßen Vorrichtung aus Figur 2;
- Figur 6: die Verläufe ausgewählter Signale der erfindungsgemäßen Vorrichtung aus Figur 3; und
- Figur 7: die Verläufe ausgewählter Signale der erfindungsgemäßen Vorrichtung aus Figur 4.

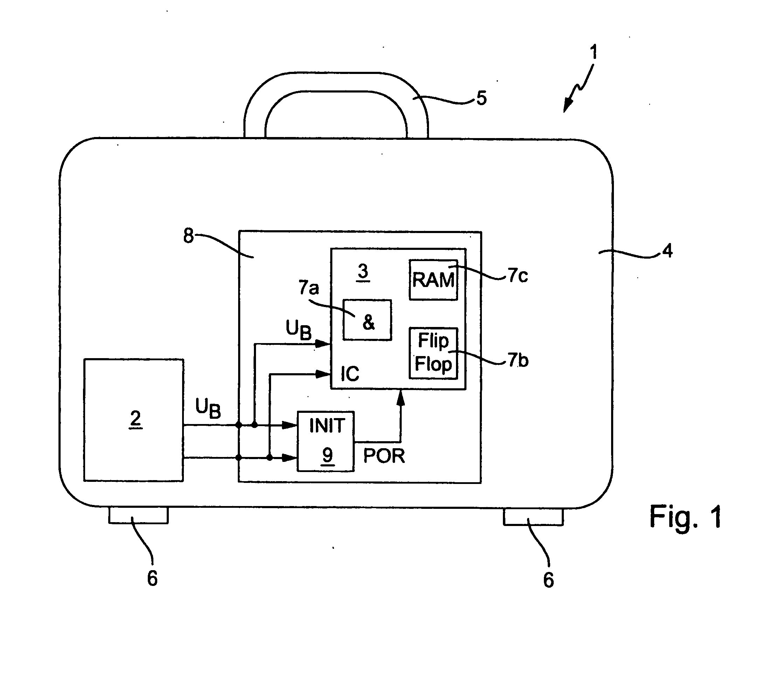

In Figur 1 ist ein erfindungsgemäßes elektrisches Gerät in seiner Gesamtheit mit dem Bezugszeichen 1 bezeichnet. Das Gerät 1 kann ein beliebiges elektrisches Gerät sein, dessen interner integrierter Schaltkreis sowohl kombinatorische Funktionen, so genannte logische Gatter, als auch Speicherelemente, wie zum Beispiel Flip-Flops oder RAM-Zellen (RAM = Random Access Memory), enthält, die sich aus Gründen der gegenseitigen Beeinflussung und der physikalisch bedingten leicht unterschiedlichen Beaufschlagung mit Strom während des Einschaltzeitpunkts unvorhersehbar verhalten und somit auch nach dem Einschalten ebenfalls unvorhersehbare Zustände annehmen. Damit befindet sich der gesamt Schaltkreis in einem undefinierten Zustand und arbeitet fehlerhaft oder gar nicht. Aus diesem Grund wird der Schaltkreis vor Inbetriebnahme, d.h. unmittelbar nach dem Anlegen der Betriebsspannung, initialisiert. Dabei werden die logischen Gatter und die Speicherelemente in einen reproduzierbaren definierten logischen Anfangszustand gebracht, damit der integrierte Schaltkreis bzw. das Gerät danach voll funktionsfähig ist.

Insbesondere ist daran gedacht, dass das Gerät 1 ein Steuergerät für einen beliebigen Einsatz, bspw. in einem Kraftfahrzeug, ein Endgerät oder ein anderes Gerät aus dem Bereich der Kommunikationstechnik, insbesondere für kryptographische Anwendungen in der Kommunikationstechnik, bspw. zur Verschlüsselung einer Übertragungsstrecke, ist. Das Gerät 1 kann mobil oder stationär, akku- oder netzbetrieben sein.

Das in Figur 1 dargestellte Gerät 1 ist als ein tragbares Gerät ausgebildet und verfügt über einen Energiespeicher 2, insbesondere in Form einer Batterie oder eines wiederaufladbaren Akkumulators, welcher eine Betriebsspannung U_{B} für einen elektrischen integrierten Schaltkreis (IC; Integrated Circuit) 3 und unter Umständen auch für andere Komponenten des Geräts 1 zur Verfügung stellt. Das Gerät 1 umfasst ein Gehäuse 4 vorzugsweise aus Kunststoff oder Metall, das in dem dargestellten Ausführungsbeispiel nach der Art eines Koffers ausgebildet ist. Zum Transportieren des Geräts 1 weist dieses einen Tragegriff 5 auf. Zum Abstellen des Geräts 1 weist es an einer dem Griff 5 gegenüberliegenden Seite Dämpfungselemente 6 auf.

Der integrierte Schaltkreis 3 des Geräts 1 verfügt über eine Vielzahl logischer Gatter 7a und Speicherelemente, beispielsweise in Form von Flip-Flops 7b oder Speichern 7c mit wahlfreiem Zugriff (RAM). Zum Initialisieren des integrierten Schaltkreises 3 unmittelbar nach dem Anlegen der Betriebsspannung U_{B} wird ein Einschalt-Rücksetz-Signal (Power-On-Reset) POR an den Schaltkreis 3 bzw. an die internen Elemente 7a, 7b, 7c angelegt.

Der integrierte Schaltkreis 3 ist als ein programmierbarer logischer Baustein beliebiger Ausgestaltung realisiert (PLD; Programmable Logic Device). In dem dargestellten Ausführungsbeispiel ist der Schaltkreis 3 in Form eines FPGAs (Field Programmable Gate Arrays) 8 realisiert. In diesem FPGA 8 ist auch eine Vorrichtung 9 zum Initialisieren des integrierten Schaltkreises 3 mittels eines POR angeordnet. Die Vorrichtung 9 ist eigentlich eine Schaltung, die ein selbsttätiges Zwangsinitialisieren des Schaltkreises 3 bewirkt. Zur Realisierung des Schaltkreises 3 und der Vorrichtung 9 werden die logischen Elemente des FPGA 8 in geeigneter Weise konfiguriert. Aufgrund der Realisierung sowohl des Schaltkreises 3 als auch der Vorrichtung 9 in Form eines gemeinsamen FPGAs 8 kann man im Sinne der vorliegenden Erfindung davon sprechen, dass die Vorrichtung 9 integraler Bestandteil des integrierten Schaltkreises 3 ist. Als Gehäuse für die Kombination aus Schaltkreis 3 und Vorrichtung 9 wird vorzugsweise ein Kugel-Rasterfeld-Gehäuse (BGA; Ball Grid Array)-Gehäuse verwendet.

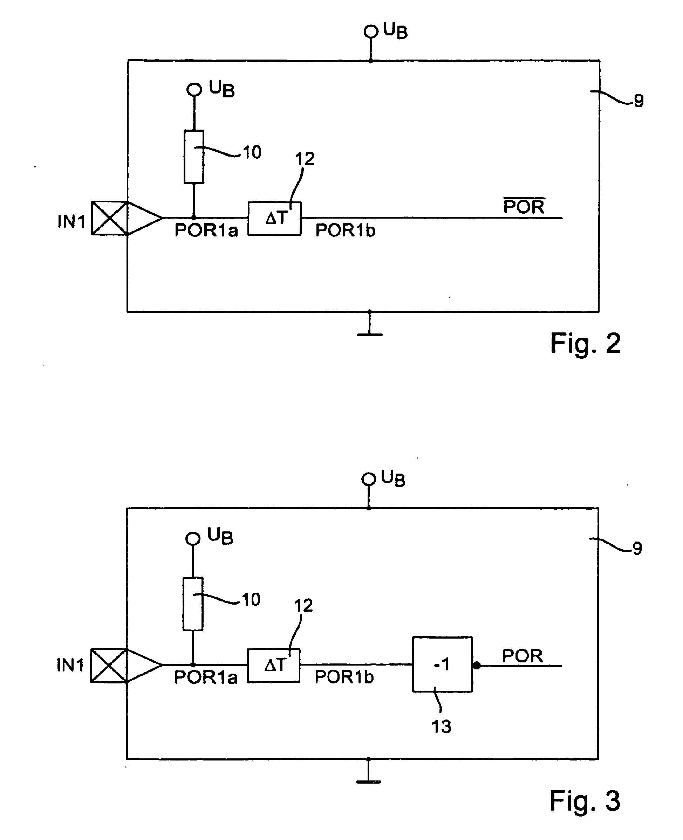

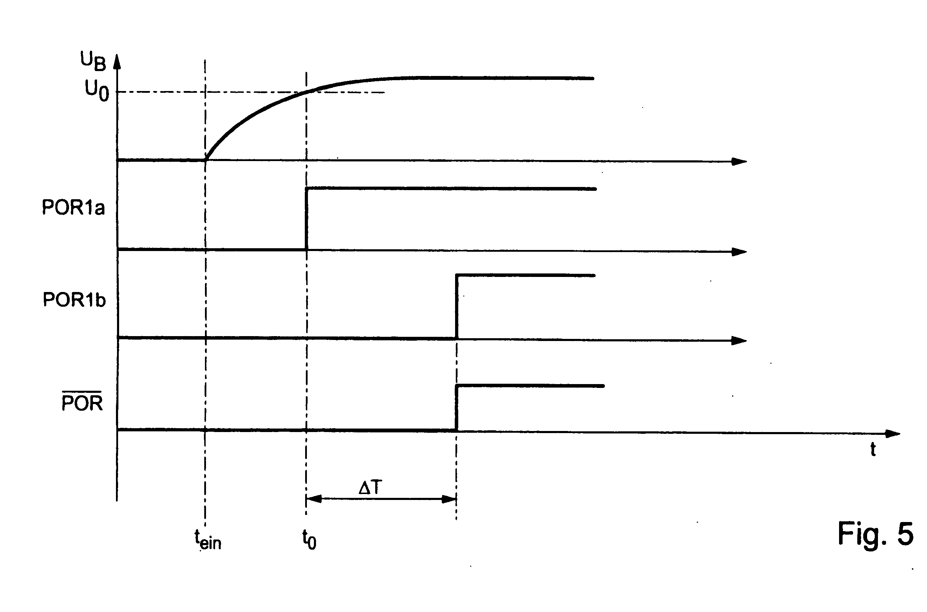

In Figur 2 ist ein erstes bevorzugtes Ausführungsbeispiel der erfindungsgemäßen Vorrichtung 9 zum Initialisieren des integrierten Schaltkreises 3 bzw. der internen Elemente 7a, 7b, 7c im Detail dargestellt. Der dazugehörige Verlauf einiger ausgewählter Signale ist in Figur 5 dargestellt. Die Vorrichtung 9 ist als integraler Bestandteil des Schaltkreises 3 zusammen mit diesem in Form eines gemeinsamen FPGAs 8 in einem BGA-Gehäuse realisiert. Viele FPGAs bieten die Möglichkeit, Ein- und Ausgänge der darin realisierten Schaltkreise (Schaltkreis 3 und Schaltung der Vorrichtung 9) flexibel nach Anforderung zu konfigurieren, und häufig auch die Möglichkeit, einen Eingangsbuffer mit bestimmten Laufzeiten, internen Ziehelementen und/oder Verzögerungscharakteristika zu versehen.

In dem Ausführungsbeispiel aus Figur 2 ist ein Eingangsbuffer eines unbeschalteten Eingangs IN1 mit dem Geschwindigkeitsmerkmal "normal" oder "langsam" konfiguriert. Dies ist durch ein Verzögerungselement 12 (ΔT) veranschaulicht. Ein konfigurierbares internes Ziehelement (bspw. in Form eines Widerstands) zur internen Versorgungsspannung U_{B} ist in Figur 2 mit dem Bezugszeichen 10 bezeichnet. Die Figur 2 zeigt die Realisierung eines POR mit Hilfe eines Eingangs IN1 und seiner inhärenten Verzögerung bzw. mit Hilfe der inhärenten Verzögerung und einer zusätzlich aufgeprägten Verzögerung.

Die Signalverläufe in Figur 5 sind über die Zeit t aufgetragen und beginnen zu einem beliebigen Zeitpunkt vor dem Anlegen der Betriebsspannung U_{B}. Zum Zeitpunkt tₑᵢₙ wird die Betriebsspannung U_{B} eingeschaltet. Sie steigt mit einer gewissen Zeitkonstante an und nähert sich asymptotisch einem Endwert. Vor Erreichen des Endwerts wird ein Schwellenwert U₀ überschritten. Dieser Zeitpunkt wird als t₀ bezeichnet. Zum Zeitpunkt t₀ befindet sich der Schaltkreis 3 mit der Vorrichtung 9 in einem operativen Zustand, das heißt der Schaltkreis 3 und die Vorrichtung 9 werden mit einer ausreichend hohen Spannung versorgt, so dass sie theoretisch voll funktionsfähig wären. Zunächst muss jedoch noch der Schaltkreis 3 initialisiert werden, um ihn beziehungsweise die internen Elemente des Schaltkreises 3, insbesondere die logischen Gatter 7a, die Flip-Flops 7b und die Speicherelemente 7c, in einen definierten Anfangszustand zu bringen.

Das Signal POR1a wird zum Zeitpunkt to durch das Ziehelement 10 sprungartig auf den aktuellen Spannungswert U_{B} angehoben. Durch die Verzögerung 12 ist der Verlauf des Signals POR1b um eine Zeit ΔT gegenüber dem Signal POR1a verzögert. Die Verzögerung 12 kann durch die inhärente Verzögerung des Eingangs IN1 und eventuell zusätzlich durch Programmierung oder Konfiguration einer aufgeprägten Verzögerung erzielt werden. Das Signal POR1b wird als invertierter POR herangezogen, der die Initialisierung des Schaltkreises 3 auslöst.

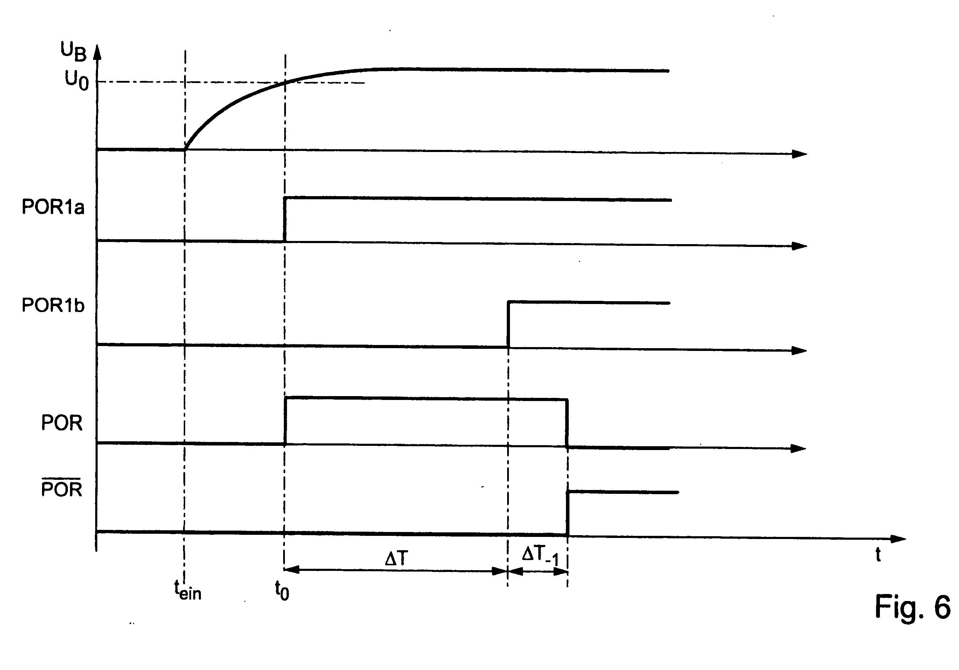

In Figur 3 ist ein weiteres Ausführungsbeispiel dargestellt, das sich von dem Beispiel aus Figur 2 dadurch unterscheidet, dass durch die Konfiguration zusätzlicher nachgeschalteter Logik, in dem Beispiel in Form eines Inverterelements 13, eine zusätzliche Verzögerung realisiert wird. Die entsprechenden Signalverläufe sind in Figur 6 über der Zeit t aufgetragen. Es ist deutlich zu erkennen, dass der POR gegenüber dem Signal POR1b nicht nur invertiert, sondern zusätzlich um eine Verzögerungszeit ΔTverzögert ist. Die Zeit ΔT-₁ entspricht der Verzögerungszeit, die durch das Invertieren des Signals POR1b mittels des Inverterelements 13 entsteht. Zum Auslösen des Zwangsinitialisierens des Schaltkreises 3 nach dem Einschalten der Betriebsspannung U_{B} wird der invertierte POR herangezogen.

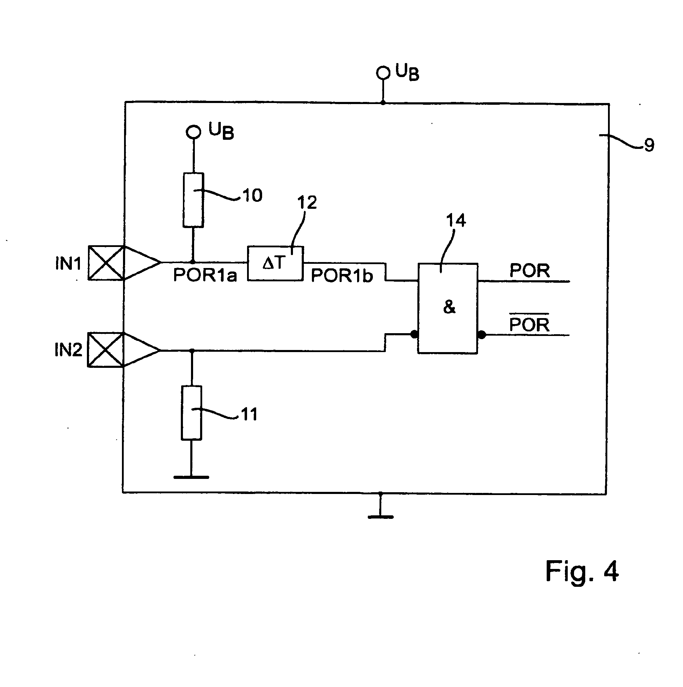

In Figur 4 ist schließlich ein weiteres Ausführungsbeispiel der vorliegenden Erfindung dargestellt, bei dem gegenüber dem Beispiel aus Figur 2 die nachgeschaltete Logik als ein logisches UND-Gatter 14 realisiert ist, das je nach Funktion in der Regel eine noch größere Verzögerungszeit aufweist als ein einfacher Inverter, bspw. der Inverter 13. Dabei ist auch der zweite funktionale Eingang des Gatters 14 zur Unterbindung von Optimierungsvorgängen durch ein verwendetes Entwicklungswerkzeug an einen ebenfalls von außen unbeschalteten Schaltkreiseingang IN2 geführt. Ein Eingangsbuffer des Eingangs IN2 ist mit dem Geschwindigkeitsmerkmal "schnell" konfiguriert. Ein internes Ziehelement nach Masse ist in Figur 4 mit den Bezugszeichen 11 bezeichnet.

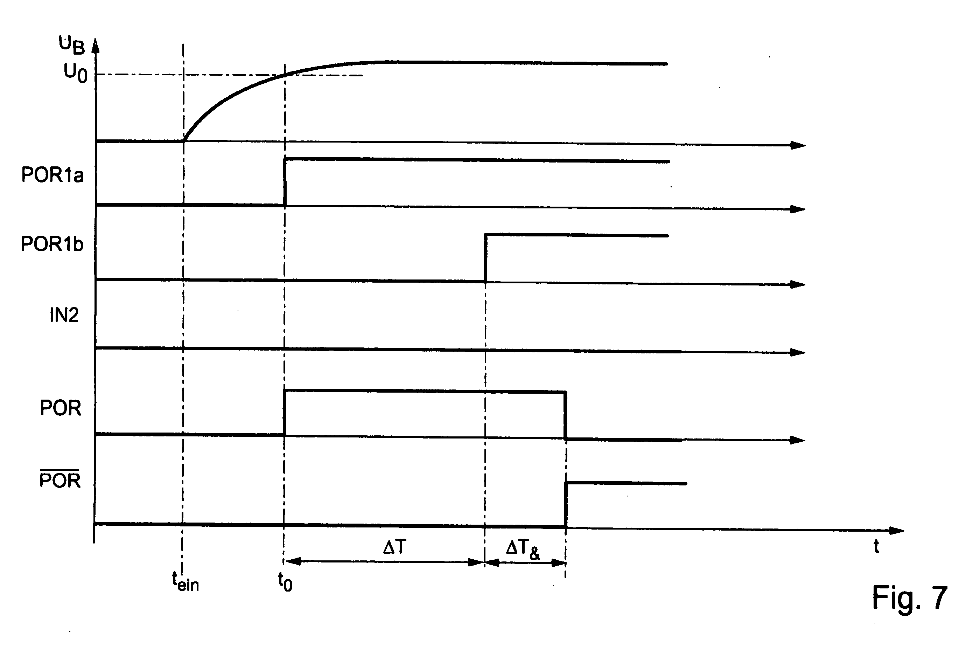

Die dem Ausführungsbeispiel aus Figur 4 entsprechenden Signalverläufe sind in Figur 7 über der Zeit t aufgetragen. Es ist deutlich zu erkennen, dass der zum Auslösen der Initialisierung herangezogene invertierte POR gegenüber dem Signal POR1b um eine Verzögerungszeit ΔT_{&} verzögert ist. Die Zeit ΔT_{&} entspricht der Verzögerungszeit, die durch die UND-Verknüpfung des Signals POR1b und des Signals IN2 mittels des Gatters 14 entsteht.

Beim Einschalten der Betriebsspannung U_{B} bleibt der Eingang IN2 durch das Ziehelement 11 auf Masse ("0"), während der Knoten POR1a durch das Ziehelement 10 sofort aktiv wird, sobald der operative Zustand des Schaltkreises 3 (t > t₀) erreicht wird. Der Knoten POR1b folgt dagegen mit der oben beschriebenen Verzögerung und wird in dem Ausführungsbeispiel aus Figur 2 direkt als negativ wirkender POR verwendet. Der positiv wirkende POR der Ausführungsbeispiele aus den Figuren 3 und 4 erhält durch die nachgeschaltete Logik (z.B. Inverter 13 oder UND-Gatter 14) noch eine entsprechende zusätzliche Verzögerung ΔT-₁ bzw. ΔT_{&}.

Es versteht sich, dass statt des UND-Gatters auch beliebig andere logische Gatter, bspw. ein OR-Gatter, ein NOR-Gatter, ein NAND-Gatter oder Kombinationen dieser Gatter, konfiguriert werden können, um eine gewünschte Verzögerung zu erzielen. Selbstverständlich können auch mehrere Gatter hintereinander geschaltet werden, so dass sich die Verzögerungszeiten der einzelnen Gatter aufsummieren. Des weiteren ist es denkbar, dass eine gewünschte Verzögerung durch eine Kombination von verschiedenen Vorschlägen aus den in den Figuren 2 bis 4 gezeigten Ausführungsbeispielen realisiert wird.

Es ist denkbar, dass im Rahmen der Konfiguration des programmierbaren logischen Bausteins 8 entweder ein vorgegebener Verzögerungswert ΔT, ΔT-₁, ΔT_{&} aktiviert oder deaktiviert wird. Alternativ ist es aber auch denkbar, dass eine aktivierte Verzögerung 12 einen von mehreren möglichen Verzögerungswerten (zum Beispiel von 1 bis 7, wobei 0 einer deaktivierten Verzögerung entspricht) annehmen kann, wobei jeder der Verzögerungswerte 1 bis 7 für eine bestimmte Verzögerungszeit im Bereich von mehreren Mikrosekunden, Millisekunden oder gar Sekunden steht.

Bei den beschriebenen Ausführungsformen stellt der Pegel des Signals POR bzw. des invertierten Signals POR das Signal zum Auslösen der Initialisierung des Schaltkreises 3 dar. Selbstverständlich wäre es auch denkbar, dass die Initialisierung des Schaltkreises 3 durch eine steigende oder eine fallende Flanke des POR oder des invertierten POR ausgelöst wird.

Erfindungsgemäß wird also eine Vorrichtung 9 vorgeschlagen, die integraler Bestandteil des zu initialisierenden Schaltkreises 3 ist und ausgelöst durch die an dem Schaltkreis 3 anliegende Betriebsspannung U_{B} ein POR beziehungsweise ein invertiertes POR erzeugt und für eine definierte Zeitdauer an den Schaltkreis 3 anlegt. Dadurch wird eine interne automatische Zwangsinitialisierung des Schaltkreises 3 bewirkt, und die von außerhalb nicht manipuliert werden kann.

## Patentansprüche

1. Vorrichtung (9) zum selbsttätigen Initialisieren eines elektrischen integrierten Schaltkreises (3) mittels eines Einschalt-Rücksetz-Signals (POR) nachdem eine Betriebsspannung (U_{B}) an den Schaltkreis (3) angelegt ist, wobei die Vorrichtung (9) integraler Bestandteil des zu initialisierenden Schaltkreises (3) ist und zusammen mit dem Schaltkreis (3) in Form eines programmierbaren logischen Bausteins (8) ausgebildet ist und Mittel zum Detektieren des angelegten Betriebsspannungssignals (U_{B}) durch Konfiguration des programmierbaren logischen Bausteins (8) realisiert sind, wobei das angelegte Betriebsspannungssignal (U_{B}) detektierbar ist, wobei
das detektierte Spannungssignal (U_{B}) verzögerbar ist und das verzögerte Spannungssignal als Einschalt-Rücksetz-Signal (POR) an den Schaltkreis (3) anlegbar ist, wobei Mittel (12; 13; 14) zum Verzögern des Spannungssignals (U_{B}) und Mittel zum Anlegen des verzögerten Spannungssignals an den Schaltkreis (3) als Einschalt-Rücksetz-Signal (POR) durch Konfiguration des programmierbaren logischen Bausteins (8) realisiert sind, **dadurch gekennzeichnet, dass** die Mittel (12; 13; 14) zum Verzögern des Spannungssignals (U_{B}) neben einer inhärenten Verzögerung eines Eingangs (IN1) des programmierbaren logischen Bausteins (8) eine dem Eingang (IN1) aufgeprägte konfigurierte zusätzliche Verzögerung (ΔT) umfassen.

2. Vorrichtung (9) nach Anspruch 1, **dadurch gekennzeichnet, dass** die Verzögerungsmittel (12, 13; 12, 14) neben einer inhärenten Verzögerung eines Eingangs des programmierbaren logischen Bausteins zusätzlich die Verzögerung (ΔT-₁, ΔT_{&}) eines dem Eingang (IN1) des programmierbaren logischen Bausteins (8) nachgeschalteten logischen Gatters (13; 14) umfassen.

3. Vorrichtung (9) nach einem der Ansprüche 1 bis 2, **dadurch gekennzeichnet, dass** der Schaltkreis (3) zusammen mit der Vorrichtung (9) als ein vor Ort programmierbarer integrierter Schaltkreis, nachfolgend als FPGA bezeichnet, realisiert ist.

4. Vorrichtung (9) nach Anspruch 3, **dadurch gekennzeichnet, dass** der Schaltkreis (3) zusammen mit der Vorrichtung (9) als ein FPGA in Flash-Technik ausgebildet ist.

5. Vorrichtung (9) nach einem der Ansprüche 1 oder 2, **dadurch gekennzeichnet, dass** der Schaltkreis (3) als ein komplex programmierbarer logischer Baustein, nachfolgend als CPLD bezeichnet, ausgebildet ist.

6. Vorrichtung (9) nach einem der Ansprüche 1 bis 5, **dadurch gekennzeichnet, dass** die Verzögerungsmittel (12; 13; 14) einen oder mehrere entsprechend konfigurierte Inverter (13) und/oder logische Verknüpfungen (14) umfassen.

7. Vorrichtung (9) nach einem der Ansprüche 1 bis 6, **dadurch gekennzeichnet, dass** die Vorrichtung (9) zusammen mit dem Schaltkreis (3) in einem Kugel-Rasterfeld-Gehäuse, nachfolgend als BGA-Gehäuse bezeichnet, angeordnet ist.

8. Verfahren zum selbsttätigen Initialisieren eines elektrischen integrierten Schaltkreises (3) mittels eines Einschalt-Rücksetz-Signals (POR) nachdem eine Betriebsspannung (U_{B}) an den Schaltkreis (3) angelegt ist, wobei der zu initialisierende Schaltkreis (3) als ein programmierbarer logischer Baustein (8) realisiert wird und
a) das angelegte Betriebsspannungssignal (U_{B}) von einem integralen Bestandteil des zu initialisierenden Schaltkreises (3) durch eine entsprechende Konfiguration des programmierbaren logischen Bausteins detektiert wird,
b) das detektierte Spannungssignal (U_{B}) verzögert wird und
c) das verzögerte Spannungssignal als Einschalt-Rücksetz-Signal (POR) an den Schaltkreis (3) angelegt wird,
wobei die Schritte b) und c) von einem integralen Bestandteil des zu initialisierenden Schaltkreises (3) durch eine entsprechende Konfiguration des programmierbaren logischen Bausteins (8) ausgeführt werden, **dadurch gekennzeichnet, dass** das Verzögern des detektierten Spannungssignals (U_{B}) mittels einer inhärenten Verzögerung eines Eingangs (IN1) des programmierbaren logischen Bausteins (8) und mittels einer dem Eingang (IN1) aufgeprägten konfigurierten zusätzliche Verzögerung (ΔT) erreicht wird.

9. Elektrischer integrierter Schaltkreis (3) mit Mitteln zum Anlegen einer Betriebsspannung (U_{B}), wobei eine Vorrichtung (9) zum selbsttätigen Initialisieren des Schaltkreises (3) mittels eines Einschalt-Rücksetz-Signals (POR) nachdem die Betriebsspannung (U_{B}) an dem Schaltkreis (3) anliegt als integraler Bestandteil des Schaltkreises (3) ausgebildet ist, wobei der Schaltkreis (3) zusammen mit der Vorrichtung (9) in Form eines programmierbaren logischen Bausteins (8) ausgebildet ist, und Mittel zum Detektieren des angelegten Betriebsspannungssignals (U_{B}) durch Konfiguration des programmierbaren logischen Bausteins (8) realisiert sind, wobei das angelegte Betriebsspannungssignal (U_{B}) detektierbar ist, wobei die Vorrichtung (9) zum Initialisieren des Schaltkreises (3) nach einem der Ansprüche 1 bis 7 ausgebildet ist.

10. Elektrisches Gerät (1) umfassend einen elektrischen integrierten Schaltkreis (3) und eine Vorrichtung (9) zum selbsttätigen Initialisieren des Schaltkreises (3) mittels eines Einschalt-Rücksetz-Signals (POR) nachdem eine Betriebsspannung (U_{B}) an dem Schaltkreis (3) angelegt ist, wobei die Vorrichtung (9) zum Initialisieren des Schaltkreises (3) integraler Bestandteil des Schaltkreises (3) ist und der Schaltkreis (3) zusammen mit der Vorrichtung in Form eines programmierbaren logischen Bausteins (8) ausgebildet ist, wobei Mittel zum Detektieren des angelegten Betriebsspannungssignals (U_{B}) durch Konfiguration des programmierbaren logischen Bausteins (8) realisiert sind, wobei das angelegte Betriebsspannungssignal (U_{B}) detektierbar ist, wobei die Vorrichtung (9) zum Initialisieren des Schaltkreises (3) nach einem der Ansprüche 1 bis 7 ausgebildet ist.

## Claims

1. Arrangement (9) for the automatic initialization of an electrical integrated circuit (3) by means of a power-on reset signal (POR) after an operating voltage (U_{B}) has been applied to the circuit (3), the arrangement (9) being an integral part of the circuit (3) to be initialized and, together with the circuit (3), being designed to take the form of a programmable logic device (8), and means for detecting the operating voltage signal (U_{B}) which is applied being produced by configuring the programmable logic device (8), the operating voltage signal (U_{B}) which is applied being detectable, and the detected voltage signal (U_{B}) being able to be delayed and the delayed voltage signal being able to be applied to the circuit (3) as a power-on reset signal (POR), means (12, 13, 14) for delaying the voltage signal (U_{B}) and means for applying the delayed voltage signal to the circuit (3) as a power-on reset signal (POR) being produced by configuring the programmable logic device (8), **characterized in that** the means (12, 13, 14) for delaying the voltage signal (U_{B}) comprise, as well as an inherent delay to one input (IN1) of the programmable logic device (8), a configured additional delay (ΔT) which is applied to the input (IN1).

2. Arrangement (9) according to claim 1, **characterized in that**, as well as an inherent delay to one input of the programmable logic device, the delay means (12, 13; 12, 14) comprise in addition the delay (ΔT-₁, ΔT_{&}) of a logic gate (13, 14) connected downstream of the input (IN1) of the programmable logic device (8).

3. Arrangement (9) according to either of claims 1 and 2, **characterized in that** the circuit (3), together with the arrangement (9), is produced in the form of a field-programmable gate array, hereinafter referred to as an FPGA.

4. Arrangement (9) according to claim 3, **characterized in that** the circuit (3), together with the arrangement (9), takes the form of a flash-based FPGA.

5. Arrangement (9) according to either of claims 1 and 2, **characterized in that** the circuit (3) takes the form of a complex programmable logic device, hereinafter referred to as a CPLD.

6. Arrangement (9) according to one of claims 1 to 5, **characterized in that** the delay means (12, 13, 14) comprise one or more suitably configured inverters (13) and/or logic gates (14).

7. Arrangement (9) according to one of claims 1 to 6, **characterized in that** the arrangement (9), together with the circuit (3), is arranged in a ball-grid array housing, hereinafter referred to as a BGA housing.

8. Method for the automatic initialization of an electrical integrated circuit (3) by means of a power-on reset signal (POR) after an operating voltage (U_{B}) has been applied to the circuit (3), the circuit (3) to be initialized being produced in the form of a programmable logic device (8) and
a) the operating voltage signal (U_{B}) which is applied being detected by an integral part of the circuit (3) to be initialized by suitable configuring of the programmable logic device,
b) the detected voltage signal (U_{B}) being delayed and
c) the delayed voltage signal being applied to the circuit (3) as a power-on reset signal (POR), steps b) and c) being performed by an integral part of the circuit (3) to be initialized by suitable configuring of the programmable logic device (8), **characterized in that** the delay to the detected voltage signal (U_{B}) is achieved by means of an inherent delay to one input (IN1) of the programmable logic device (8) and by means of a configured additional delay (ΔT) which is applied to the input (IN1).

9. Electrical integrated circuit (3) having means for applying an operating voltage (U_{B}), a arrangement (9) for the automatic initialization of the circuit (3) by means of a power-on reset signal (POR) after the operating voltage (U_{B}) has been applied to the circuit (3) taking the form of an integral part of the circuit (3), the circuit (3), together with the arrangement (9), taking the form of a programmable logic device (8), and means for detecting the operating voltage signal (U_{B}) which is applied being produced by configuring the programmable logic device (8), the operating voltage signal (U_{B}) which is applied being detectable and the arrangement (9) for initializing the circuit (3) being designed in accordance with one of claims 1 to 7.

10. Electrical device (1) comprising an electrical integrated circuit (3) and a arrangement (9) for the automatic initialization of the circuit (3) by means of a power-on reset signal (POR) after an operating voltage (U_{B}) has been applied to the circuit (3), the arrangement (9) for initializing the circuit (3) being an integral part of the circuit (3) and the circuit (3), together with the arrangement, taking the form of a programmable logic device (8), means for detecting the operating voltage signal (U_{B}) which is applied being produced by configuring the programmable logic device (8), the operating voltage signal (U_{B}) which is applied being detectable and the arrangement (9) for initializing the circuit (3) being designed in accordance with one of claims 1 to 7.

## Revendications

1. Dispositif (9) pour initialiser automatiquement un circuit électrique intégré (3) à l'aide d'un signal de branchement-remise à zéro (POR) après avoir appliqué une tension de fonctionnement (U_{B}) à ce circuit (3), selon lequel
- le dispositif (9) fait partie intégrante du circuit (3) à initialiser et il est réalisé avec le circuit (3) sous la forme d'un composant logique programmable (8), et
- des moyens sont réalisés pour détecter le signal de tension de fonctionnement (U_{B}) appliquée, par la configuration du composant logique programmable (8),
- le signal de tension de fonctionnement (U_{B}) appliquée, est détecté,
- le signal de tension (U_{B}), détecté, est susceptible d'être retardé et le signal de tension retardé est appliqué comme signal de branchement-remise à zéro (POR) au circuit (3),
- des moyens de temporisation (12, 13, 14) du signal de tension (U_{B}) et des moyens appliquent le signal de tension temporisé au circuit (3) comme signal de branchement-remise à l'état initial (POR) par la configuration du composant logique programmable (8),
dispositif **caractérisé en ce que**
- les moyens de temporisation (12, 13, 14) du signal de tension (U_{B}) assurent en plus du retard inhérent à l'entrée (IN1) du composant logique programmable (8), un retard (ΔT) supplémentaire, configuré, appliqué à l'entrée (IN1).

2. Dispositif (9) selon la revendication 1,
**caractérisé en ce que**
les moyens de temporisation (12, 13 ; 12, 14) assurent en plus du retard propre d'une entrée du composant logique programmable en plus des retards (ΔT-1, ΔT&), d'une porte logique (13, 14) en aval de l'entrée (IN1) du composant logique programmable (8).

3. Dispositif (9) selon l'une des revendications 1 à 2,
**caractérisé en ce que**
le circuit (3) avec le dispositif (9) est réalisé comme un circuit intégré programmable sur place, appelé ci-après circuit FPGA.

4. Dispositif (9) selon la revendication 3,
**caractérisé en ce que**
le circuit (3) avec le dispositif (9) est réalisé comme circuit FPGA en technique flash.

5. Dispositif (9) selon l'une des revendications 1 ou 2,
**caractérisé en ce que**
le circuit (3) est un circuit logique complexe programmable désigné ci-après circuit CPLD.

6. Dispositif (9) selon l'une des revendications 1 à 5,
**caractérisé en ce que**
les moyens de temporisation (12, 13, 14) comprennent un ou plusieurs inverseurs (13) configurés de manière appropriée et/ou des combinaisons logiques (14).

7. Dispositif (9) selon l'une des revendications 1 à 6,
**caractérisé en ce que**
le dispositif (9) avec le circuit (3) est logé dans un boîtier à matrices de billes, désigné boîtier BGA.

8. Procédé d'initialisation automatique d'un circuit intégré électrique (3) à l'aide d'un signal de branchement-remise à l'état initial (POR) après application de la tension de fonctionnement (U_{B}) au circuit (3) selon lequel
- le circuit à initialiser (3) est réalisé comme composant logique programmable (8), et
a) le signal de tension de fonctionnement (U_{B}), appliquée, est détecté par un composant faisant partie intégrale du circuit (3) à initialiser par une configuration appropriée du composant logique programmable,
b) on temporise le signal de tension détecté (U_{B}), et
c) on applique le signal de tension retardé comme signal de branchement-remise à zéro (POR) au circuit de commutation (3),
- les étapes b) et c) étant exécutées par un composant faisant partie intégrale du circuit à initialiser (3) par une configuration appropriée du composant logique programmable (8),
**caractérisé en ce que**
la temporisation du signal de tension détecté (U_{B}) est réalisée par la temporisation propre de l'entrée (IN1) du composant logique programmable (8) et par une temporisation supplémentaire (ΔT) configurée, appliquée à l'entrée (IN1).

9. Circuit électrique intégré (3) comportant des moyens pour appliquer une tension de fonctionnement (U_{B}),
* un dispositif (9) pour initialiser automatiquement le circuit (3) à l'aide d'un signal de branchement-remise à l'état initial (POR) après application de la tension de fonctionnement (U_{B}) au circuit (3) comme composant faisant partie intégrale du circuit (3),
* le circuit (3) avec le dispositif (9) étant réalisé sous la forme d'un composant logique programmable (8) et les moyens pour détecter le signal de tension de fonctionnement (U_{B}) appliquée, sont réalisés par la configuration du composant logique programmable (8),
- dans lequel on détecte le signal de la tension de fonctionnement (U_{B}) appliquée, et
- le dispositif (9) est réalisé pour initialiser le circuit (3) selon l'une des revendications 1 à 7.

10. Appareil électrique (1) comportant un circuit électrique intégré (3) et un dispositif (9) pour initialiser automatiquement le circuit (3) par un signal de branchement-remise à zéro (POR) après application d'une tension de fonctionnement (U_{B}) au circuit (3),
- le dispositif (9) pour initialiser le circuit (3) est un composant intégral du circuit (3) réalisé avec le dispositif sous la forme d'un composant logique programmable (8),
- des moyens étant prévus pour détecter le signal de tension de fonctionnement (U_{B}) appliquée, par la configuration du composant logique programmable (8),
dans lequel
- on détecte le signal de tension de fonctionnement appliquée (U_{B}), et
- le dispositif (9) pour initialiser le circuit de commutation (3) est réalisé selon l'une des revendications 1 à 7.
